# EUROPEAN PATENT SPECIFICATION

(11) **EP 0 326 405 B1**
(45) Date of publication and mention of the grant of the patent: **11.08.1993**
(21) Application number: 89300805.2
(22) Date of filing: 27.01.1989
(51) Int. Cl.: C23C 16/50, H01J 37/32

(54) **Plasma chemical vapour reaction apparatus**
Anlage zur plasma-chemischen Dampfphasenreaktion
Dispositif de réaction chimique en phase vapeur utilisant un plasma

(30) Priority: 27.01.1988 JP 18145/88
(43) Date of publication of application: 02.08.1989
(73) Proprietor: SEMICONDUCTOR ENERGY LABORATORY CO., LTD., Atsugi-shi Kanagawa-ken, 243 (JP)
(72) Inventor: Hirose, Naoki, Atsugi-shi Kanagawa-ken (JP); Inshima, Takashi, Atsugi-shi Kanagawa-ken (JP)
(74) Representative: Milhench, Howard Leslie

(56) References cited:
- EP-A- 0 267 513
- JAPANESE JOURNAL OF APPLIED PHYSICS, vol. 22, no. 4, part 2, April 1983, pp. L210-L212, Tokyo, JP; S. MATSUO et al.: "Low temperature chemical vapor deposition method utilizing an electron cyclotron resonance plasma"
- JAPANESE JOURNAL OF APPLIED PHYSICS/PART 2: LETTERS, vol. 26, no. 6, June 1987, pp. L1032-L1034, Tokyo, JP; H. KAWARADA et al.: "Large area chemical vapour deposition of diamond particles and films using magneto-microwave plasma"
- PATENT ABSTRACTS OF JAPAN, vol. 11, no. 317 (C-452)[2764], 15 October 1987; & JP-A-62 103 370

## Description

### BACKGROUND OF THE INVENTION

The present invention relates to a plasma chemical vapour reaction apparatus, and particularly, though not exclusively, relates to a plasma ECR (Electron Cyclotron Resonance) CVD (Chemical Vapour Deposition) apparatus.

Plasma ECR CVD apparatuses are disclosed, for example, in the Matsuo et al article "Low Temperature Chemical Vapour Deposition Method Utilizing an Electron Cyclotron Resonance Plasma" published in the Japanese Journal of Applied Physics, Vol 22, No. 4, April 1983, pp. L210-L212, and in the Kawarada et al article "Large Area Chemical Vapour Deposition of Diamond Particles and Films Using Magneto-Microwave Plasma" published in the Japanese Journal of Applied Physics, Vol 26, No.6 June 1987, pp. L1032-L1034. Both of these Matsuo et al and Kawarada et al articles disclose a plasma chemical vapour reaction apparatus comprising a reaction chamber, a gas supply system for introducing a reactive gas into the reaction chamber, Helmholtz coils for developing an axial magnetic field within the reaction chamber, a microwave generator for inputting microwave energy into the reaction chamber in an axial direction, the magnetic field and microwave energy producing conditions for sustaining electron cyclotron resonance within the reactive gas, and a substrate holder for supporting a substrate at a position in the reaction chember such as to have a surface of the substrate exposed to deposition of material from the plasma.

The ECR CVD technique has attracted the interest of researchers due to its high rate excitation ability. As a deposition method it makes use of ECR (Electron Cyclotron Resonance) which takes place between charged particles and microwaves in a magnetic field. Since the energy induced by ECR is very high, the disadvantage arises that a substrate to be treated tends to suffer from sputtering damage. As shown in the abovementioned Matsuo et al article, substrates have therefore been located spaced apart from the position in which the magnetic field and microwave energy conditions required to establish ECR are satisfied and the plasma products are extracted onto the substrate by a divergent magnetic field. This has given rise to the disadvantage of the prior art ECR CVD technique that the plasma density in the substrate region is relatively small and the pressure of the reactive gas in the apparatus has to be of the order of 10⁻⁴ Torr (1 Torr = 133.3 N/m²) in order to enable the excited gas to reach the substrate to be processed, and highly crystallized depositions, such as of diamond, could not be formed.

### OBJECTS AND SUMMARY OF THE INVENTION

It is thus an object of the present invention to provide a plasma chemical vapour reaction apparatus capable of effective treatment of a substrate.

It is another object of the present invention to provide a plasma chemical vapour reaction apparatus which is capable of depositing highly crystallized films on substrates.

According to the present invention there is provided a plasma chemical vapour reaction apparatus comprising a reaction chamber; a gas supply system for introducing a reactive gas into said reaction chamber; magnetic field inducing means for inducing a magnetic field in said reaction chamber; a microwave generator for inputting microwave energy into said reaction chamber; said magnetic field inducing means and said microwave generator producing conditions in operation of said apparatus for sustaining electron cyclotron resonance within a reactive gas plasma in said reaction chamber; and a substrate holder for supporting a substrate in said reaction chamber at a position to have a surface thereof exposed to particulate material from said reactive gas plasma; all as known from the Matsuo and Kawarada articles abovementioned; the apparatus being characterized in accordance with the invention in that second magnetic field inducing means are provided for generating centripetal forces such as to pinch the plasma; and said substrate holder and the first-mentioned and second magnetic field inducing means are arranged so that the substrate holder is located where the magnetic fields of the first-mentioned and second magnetic field inducing means interact so as to produce a resultant magnetic field having a field strength gradient directed to concentrate the plasma towards the substrate that is to be treated.

The invention also provides a plasma chemical vapour reaction method comprising: disposing a substrate in a reaction chamber; introducing a reactive gas into said reaction chamber; establishing a magnetic field within said reaction chamber and inputting to said reaction chamber microwave energy propagated approximately parallel to said magnetic field so as to produce a reactive gas plasma by the development of electron cyclotron resonance within the reaction chamber; and carrying out plasma processing with said plasma gas on said substrate; as known from the Matsuo and Kawarada articles abovementioned; the method being characterized in accordance with the invention in that the reactive gas plasma is additionally subjected to a further magnetic field developing centripetal forces such as to pinch the plasma; and the substrate is located within the reaction chamber at a position whereat the magnetic fields applied to the plasma interact so as to produce a resultant magnetic field having a field strength gradient which is directed to concentrate the plasma towards the substrate that is to be treated.

Further features of the invention are set forth in the appended claims and, together with the abovementioned features, will be well understood by consideration of the following detailed description given with reference to the accompanying drawings.

### BRIEF DESCRIPTION OF THE DRAWINGS

Fig. 1 is a schematic view showing an exemplary plasma CVD apparatus in accordance with the present invention;
Figs. 2(A) and 2(B) are cross-sectional and plan views respectively showing Ioffe bars comprising electromagnets;
Figs. 3(A) and 3(B) are cross-sectional and plan views respectively showing Ioffe bars comprising permanent magnets;
Fig. 4 is a cross-sectional view showing a modification of the Ioffe bars illustrated in Figs. 3(A) and 3(B);
Fig. 5 is a schematic illustration showing the magnetic field strength profile in the plasma generating space of an ECR CVD apparatus which does not embody the present invention;
Fig. 6 is a schematic illustration showing the magnetic field strength profile in the plasma generating space of an apparatus in accordance with the present invention; and
Fig. 7 is an explanatory view showing the drift forces exerted on plasma in an apparatus in accordance with the present invention.

### DETAILED DESCRIPTION OF THE EMBODIMENTS

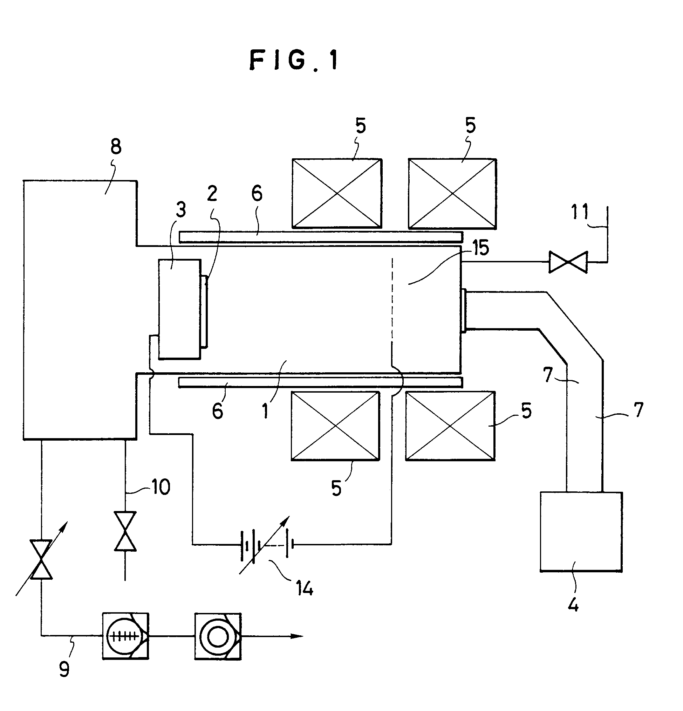

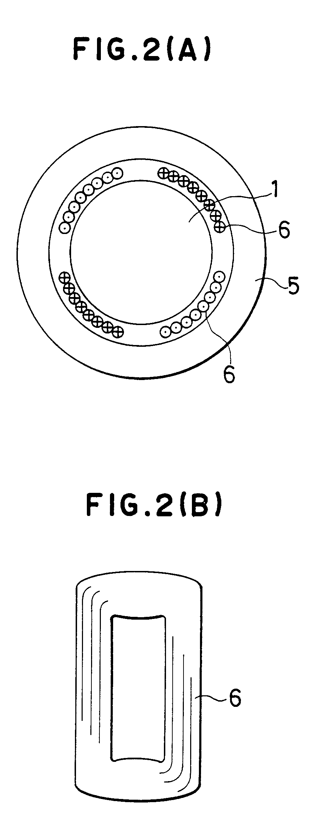

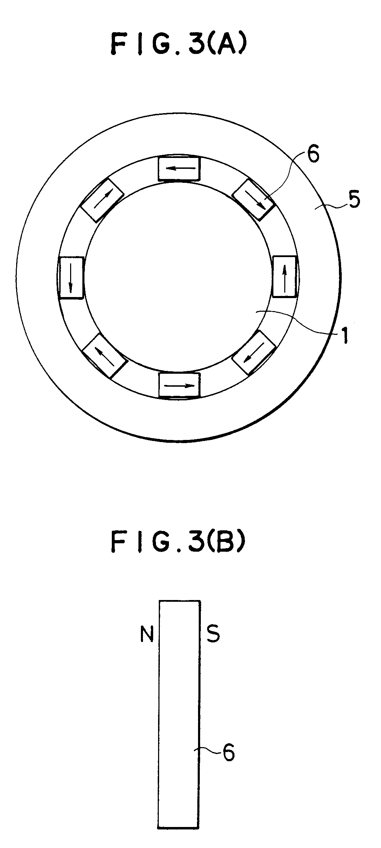

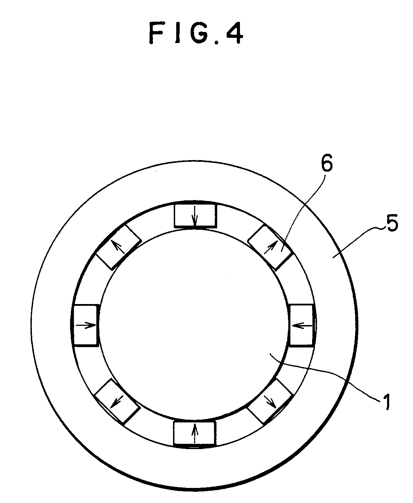

Referring now to Fig. 1, an exemplary microwave enhanced plasma CVD apparatus in accordance with the present invention is illustrated. The apparatus comprises a reaction chamber in which a plasma generating space 1 and an auxiliary space 8 are defined which can be maintained at an appropriate negative pressure by means of an evacuating system 9. Gas introduction systems 11 and 10 are connected to the plasma generating space 1 and the auxiliary space 8 respectively. Microwave energy is introduced into the plasma generating space 1 from a microwave generator 4 through a waveguide 7. Helmholtz coils 5 and Ioffe bars 6 are located around the plasma generating space 1. Ioffe bars are known per se, for example from Patent Abstracts of Japan, Vol 11, No. 317(C-452)(2764) dated 15 October 1987. The Ioffe bars 6 are arranged parallel to the microwave propagation direction and as depicted in Figs. 2(A) and 2(B) can be constructed with electromagnets or as depicted in Figs. 3(A) and 3(B) with permanent magnets. In Fig. 3(A) the arrows indicate the magnetic moments of the permanent magnets. Fig. 4 shows a modification of the Ioffe bars illustrated in Figs. 3(A) and 3(B). A substrate 2 to be treated is mounted on a substrate holder 3 which is adapted to heat the substrate 2. The substrate holder 3 is made of a ceramic, e.g. aluminium nitride, which causes little disturbance of the magnetic field induced by the magnets 5 and 6.

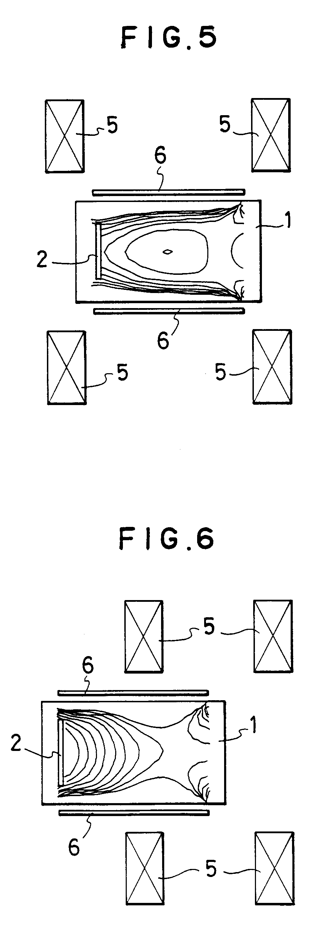

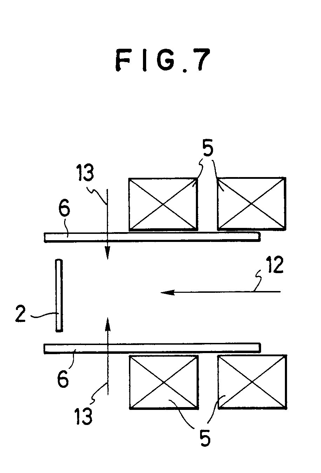

The relative location of the substrate 2 with respect to the Helmholtz coils 5 is very important. Fig. 5 shows the configuration of an ECR CVD apparatus which does not embody the present invention and shows the location of the coils 5 relative to the substrate 2, the substrate being placed between the two coils. A number of curves have been drawn within the plasma generating space 1 to trace equi-strength surfaces of the magnetic field induced by the magnets 5 and 6. The magnetic field strength increases as a function of the distance from the centre of the substrate 2. In this apparatus configuration the plasma experiences drift forces towards the weaker magnetic field strength positions, i.e. in directions away from the substrate 2. Consequently, there is a tendency to gather plasma in the generating space 1 rather than in the region of the substrate surface to be processed. Generally speaking, the drift force exerted on plasma in a magnetic field is in proportion to -grad B, where B is the absolute strength of the magnetic field. The equi-strength surfaces in the magnetic field that is established in the case of the present invention are shown in Fig. 6. The magnetic field as shown becomes weaker at a nearer position to the substrate 2. The drift forces exerted on the plasma are shown in Fig. 7 by the arrows. The arrow 12 represents a drift force which serves for drifting plasma towards the substrate 2 and is mainly induced by the Helmholtz coils 5. The arrows 13 represents a centripetal force which is induced mainly by the Ioffe bars 6.

Next, an exemplary method for depositing carbon films on a substrate by use of the apparatus according to the invention will be described. After evacuating the chamber by means of the evacuating system 9, hydrogen is admitted to the plasma generating space 1 at 10SCCM from the gas feeding system 11. The Helmholtz coils 5 are energized in order to induce a 2k Gauss magnetic field in the plasma generating space 1. The Ioffe bars 6 modify the magnetic field to produce a centripetal drift force. 2.45 GHz microwave energy is introduced from the microwave generator 4 at 500 W. By virtue of resonance between the microwaves and hydrogen atoms and electrons, excited hydrogen ions and electrons are produced. The resonance may take place in an ECR mode, a MCR (Mixed Cyclotron Resonance) mode or the whistler mode. The pressure of hydrogen is maintained at 0.1 Pa. Hence, high energy hydrogen atoms or electrons collide with the surface of the substrate 2 and perform plasma cleaning.

After cleaning the substrate surface, the introduction of hydrogen is stopped and a carbon compound gas such as CH₄, C₂H₄, C₂H₂, CH₃OH or C₂H₅OH for example is introduced instead. The carbon compound gas is excited in the same manner as described above for the hydrogen cleaning process and deposits a carbon thin film of diamond or an i-carbon. In accordance with the results of experiments that we have conducted, diamond films can be formed when the substrate temperature is not lower than 450°C. When the deposition was carried out in the same manner but without a magnetic field, only graphite films were formed.

Electron beam diffraction images of thin carbon films deposited in accordance with the present invention were taken. In the image, spot patterns indicative of the existence of diamond structure were observed together with halo patterns which are peculiar to amorphous structures. This means that the carbon films were made of i-carbon. It was confirmed that i-carbon (diamond like carbon) films can be formed when the substrate is not heated. The diamond like carbon is an amorphous carbon, but has a highly abrasion-proof surface and a high thermal conductivity. When the substrate temperature was elevated, the halo patterns gradually disappeared and, at not lower than 650°C, the thin films were confirmed to be diamond films.

The Raman spectrum of the film had a blunt peak about 1500 cm⁻¹ and a sharp peak about 1333 cm⁻¹ which indicates the existence of diamond.

While several embodiments have been specifically described, it is to be appreciated that the present invention is not limited to the particular examples described and that modifications and variations can be made without departure from the invention as defined by the appended claims. Examples of such modifications are described below.

Improved silicon carbide films and aluminium nitride films can be formed in accordance with the present invention using methyl silane and using a gaseous aluminium compound and ammonia respectively. Also, tungsten, titanium, molybdenum or their silicates having high melting points can be formed in the same manner.

The crystallinity of films manufactured in accordance with the present invention could be increased by adding water or oxygen to the reactive gas. Although the specific embodiment described concerns deposition, the present invention is applicable to general plasma processes effected in a magnetic field, such as plasma etching processes and plasma cleaning processes.

Optionally, a UV light source may be provided for irradiating the reactive gas in the chamber in order to ensure that the reaction gas is in an excited state near to the substrate to be processed. Also, a DC bias voltage may be applied to the reaction gas in the plasma state. The bias can be applied by means of a voltage supply 14 connected between the substrate holder 3 and an electrode mesh 15 as illustrated in Fig. 1. The bias voltage is applied with the holder 3 being the cathode in case of Si deposition, and with the mesh 15 being the cathode in case of carbon deposition or etching using F⁻ or B⁻. In the case of the holder being made from a conductive material, the bias voltage consists only of a DC component. In the case of the holder being made from a non-conductive material, the bias voltage consists of a DC component and a superimposed AC component.

## Claims

1. A plasma chemical vapour reaction apparatus comprising:-
a reaction chamber (1);
a gas supply system (10, 11) for introducing a reactive gas into said reaction chamber;
magnetic field inducing means (5) for inducing a magnetic field in said reaction chamber;
a microwave generator (4) for inputting microwave energy into said reaction chamber;
said magnetic field inducing means (5) and said microwave generator (4) producing conditions in operation of said apparatus for sustaining electron cyclotron resonance within a reactive gas plasma in said reaction chamber (1); and
a substrate holder (3) for supporting a substrate (2) in said reaction chamber at a position to have a surface thereof exposed to particulate material from said reactive gas plasma;
characterized in that:-
second magnetic field inducing means (6) are provided for generating centripetal forces such as to pinch the plasma; and
said substrate holder (3) and the first-mentioned and second magnetic field inducing means (5, 6) are arranged so that the substrate holder (3) is located where the magnetic fields of the first-mentioned and second magnetic field inducing means (5, 6) interact so as to produce a resultant magnetic field having a field strength gradient directed to concentrate the plasma towards the substrate that is to be treated.

2. The apparatus of claim 1 wherein the first-mentioned magnetic field inducing means (5) comprises Helmholtz coils surrounding said reaction chamber (1).

3. The apparatus of claim 1 or 2 wherein said second magnetic field inducing means comprises a plurality of elongate permanent magnets arranged around the periphery of the reaction chamber (1), said magnets having their magnetic poles extending along transversely opposed longitudinal edges thereof and being arranged such that their magnetic moments alternate as between one magnet and the next around the periphery of the reaction chamber, or an equivalent electromagnetic arrangement.

4. The apparatus of claims 2 and 3 wherein said elongate permanent magnets, or equivalent electromagnetic arrangement, extend within the Helmholtz coils (5) and substantially beyond one axial end thereof to a location substantially spaced from said one axial end and generally corresponding to the location of said substrate holder (3).

5. A plasma chemical vapour reaction method comprising:-
disposing a substrate in a reaction chamber;
introducing a reactive gas into said reaction chamber;
establishing a magnetic field within said reaction chamber and inputting to said reaction chamber microwave energy propagated approximately parallel to said magnetic field so as to produce a reactive gas plasma by the development of electron cyclotron resonance within the reaction chamber; and carrying out plasma processing with said plasma gas on said substrate;
characterized in that:-
the reactive gas plasma is additionally subjected to a further magnetic field developing centripetal forces such as to pinch the plasma; and
the substrate is located within the reaction chamber at a position whereat the magnetic fields applied to the plasma interact so as to produce a resultant magnetic field having a field strength gradient directed to concentrate the plasma towards the substrate that is to be treated.

## Patentansprüche

1. Anlage zur plasma-chemischen Dampfphasenreaktion, mit:
- einer Reaktionskammer (1);
- einem Gaszuführsystem (10, 11) zum Einleiten eines Reaktionsgases in die Reaktionskammer;
- einer Magnetfeld-Erzeugungseinrichtung (5) zum Erzeugen eines Magnetfelds in der Reaktionskammer;
- einem Mikrowellengenerator (4) zum Einleiten von Mikrowellenenergie in die Reaktionskammer;
- wobei die Magnetfeld-Erzeugungseinrichtung (5) und der Mikrowellengenerator (4) Bedingungen beim Betrieb der Anlage zum Aufrechterhalten von Elektronzyklotronresonanz innerhalb eines Reaktionsgasplasmas in der Reaktionskammer (1) erzeugen; und
- einem Substrathalter (3) zum Halten eines Substrats (2) in der Reaktionskammer an einer solchen Position, daß eine Oberfläche desselben einem Teilchenmaterial aus dem Reaktionsgasplasma ausgesetzt ist;
**dadurch gekennzeichnet**, daß:
- eine zweite Magnetfeld-Erzeugungseinrichtung (6) vorhanden ist, um Zentripetalkräfte zu erzeugen, wie sie erforderlich sind, um das Plasma zusammenzudrücken; und
- der Substrathalter (3) und die erstgenannte und die zweite Magnetfeld-Erzeugungseinrichtung (5, 6) so angeordnet sind, daß der Substrathalter (3) dort liegt, wo die Magnetfelder der erstgenannten und der zweiten Magnetfeld-Erzeugungseinrichtung (5, 6) so wechselwirken, daß sie ein resultierendes Magnetfeld mit einem Feldstärkegradienten erzeugen, der so gerichtet ist, daß das Plasma zu dem zu behandelnden Substrat hin konzentriert wird.

2. Anlage nach Anspruch 1, bei der die erstgenannte Magnetfeld-Erzeugungseinrichtung (5) Helmholtz-Spulen aufweist, die die Reaktionskammer (1) umgeben.

3. Anlage nach einem der Ansprüche 1 oder 2, bei der die zweite Magnetfeld-Erzeugungseinrichtung mehrere langgestreckte Permanentmagneten aufweist, die um den Umfang der Reaktionskammer (1) herum angeordnet sind, wobei sich die Magnetpole dieser Magneten entlang in Querrichtung gegenüberliegenden Längskanten derselben erstrecken und so angeordnet sind, daß ihre magnetischen Momente zwischen einem Magneten und dem nächsten um den Umfang der Reaktionskammer einander abwechseln, oder sie eine äquivalente elektromagnetische Anordnung aufweist.

4. Anlage nach den Ansprüchen 2 und 3, bei der die langgestreckten Permanentmagneten, oder die äquivalente elektromagnetische Anordnung, sich innerhalb der Helmholtz-Spulen (5) und wesentlich über ein axiales Ende derselben hinaus bis zu einem Ort erstrecken, der wesentlich von dem einen axialen Ende beabstandet ist und im wesentlichen dem Ort des Substrathalters (3) entspricht.

5. Verfahren für plasma-chemische Dampfphasenreaktion, mit:
- Anordnen eines Substrats in einer Reaktionskammer;
- Einleiten eines Reaktionsgases in die Reaktionskammer;
- Erzeugen eines Magnetfelds innerhalb der Reaktionskammer, und Einleiten von Mikrowellenenergie in die Reaktionskammer, die sich im wesentlichen parallel zum Magnetfeld ausbreitet, um durch den Aufbau von Elektronzyklotronresonanz innerhalb der Reaktionskammer ein Reaktionsgasplasma zu erzeugen; und Ausführen einer Plasmaverarbeitung auf dem Substrat mit dem Plasmagas;
**dadurch gekennzeichnet**, daß:
- das Reaktionsplasma zusätzlich einem weiteren Magnetfeld unterworfen wird, das Zentripetalkräfte erzeugt, um das Plasma zusammenzudrücken; und
- das Substrat innerhalb der Reaktionskammer an einer Stelle angeordnet wird, in der die an das Plasma angelegten Magnetfelder so wechselwirken, daß sie ein resultierendes Magnetfeld mit einem Feldstärkegradienten erzeugen, der so gerichtet ist, daß das Plasma auf das zu behandelnde Substrat hin konzentriert wird.

## Revendications

1. Dispositif de réaction chimique en phase vapeur utilisant un plasma, qui comprend :
une chambre de réaction (1);
un système d'alimentation en gaz (10, 11) pour introduire un gaz réactif dans ladite chambre de réaction;
un dispositif produisant un champ magnétique (5) pour induire un champ magnétique dans ladite chambre de réaction;
un générateur de micro-ondes (4) pour introduire de l'énergie micro-ondes dans ladite chambre de réaction;
ledit dispositif de production de champ magnétique (5) et ledit générateur de micro-ondes (4) créant des conditions fonctionnelles dans ledit dispositif pour maintenir une résonance de cyclotron d'électrons à l'intérieur d'un plasma de gaz réactif dans ladite chambre de réaction (1); et
un support de substrat (3) pour supporter un substrat (2) dans ladite chambre de réaction dans une position telle qu'une surface de ce substrat est exposée aux matières en particules provenant dudit plasma de gaz réactif;
**caractérisé en ce que**
des deuxièmes dispositifs de production d'un champ magnétique (6) sont prévus pour créer des forces centripètes permettant de pincer le plasma; et
ledit support de substrat (3) et les dispositifs produisant un champ magnétique mentionnés en premier lieu et en second lieu (5, 6) sont disposés de façon que le support de substrat (3) soit situé là où les champs magnétiques des dispositifs de production de champ magnétique mentionnés en premier lieu et en second lieu (5, 6) agissant l'un sur l'autre de façon à produire un champ magnétique résultant ayant un gradient d'intensité de champ dirigé de manière à concentrer le plasma vers le substrat qui doit être traité.

2. Dispositif selon la revendication 1, dans lequel le dispositif de production de champ magnétique mentionné en premier lieu (5) comprend des bobines de Helmholtz entourant ladite chambre de réaction (1).

3. Dispositif selon la revendication 1 ou 2, dans lequel ledit deuxième dispositif produisant un champ magnétique comporte plusieurs aimants permanents allongés disposés autour de la périphérie de la chambre de réaction (1), lesdits aimants ayant leurs pôles magnétiques s'étendant le long des bords longitudinaux transversalement opposés de ceux-ci et étant disposés de façon que leurs moments magnétiques soient alternés d'un aimant à l'aimant suivant sur la périphérie de la chambre de réaction, ou bien un dispositif électromagnétique équivalent.

4. Dispositif selon les revendications 2 et 3, dans lequel lesdits aimants permanents allongés ou ledit dispositif électromagnétique équivalent s'étendent à l'intérieur des bobines de Helmholtz (5) et essentiellement au-delà d'une extrémité axiale de celles-ci jusqu'à un emplacement essentiellement écarté de ladite extrémité axiale et correspondant généralement à l'emplacement dudit support de substrat (3).

5. Procédé de réaction chimique en phase vapeur utilisant un plasma, qui comprend :
le placement d'un substrat dans une chambre de réaction;
l'introduction d'un gaz réactif dans ladite chambre de réaction;
la création d'un champ magnétique dans ladite chambre de réaction et l'introduction dans ladite chambre de réaction d'énergie micro-ondes propagée en direction approximativement parallèle audit champ magnétique, de façon à produire un plasma de gaz réactif par l'apparition d'une résonance de cyclotron d'électrons dans la chambre de réaction et la réalisation d'un traitement par plasma dudit substrat au moyen dudit gaz de plasma;
**caractérisé en ce que**
le plasma de gaz réactif est soumis en outre à un autre champ magnétique créant des forces centripètes de manière à pincer le plasma; et
le substrat est situé dans la chambre de réaction en une position où les champs magnétiques appliqués au plasma agissent l'un sur l'autre, de façon à produire un champ magnétique résultant ayant un gradient d'intensité de champ orienté de manière à concentrer le plasma vers le substrat qui doit être traité.
